# EUROPEAN PATENT APPLICATION

(11) **EP 1 437 684 A1**
(43) Date of publication of application: **14.07.2004**
(21) Application number: 03290044.1
(22) Date of filing: 08.01.2003
(51) Int. Cl.: G06K 19/077, H01L 23/498

(54) **Module for a hybrid card**

(71) Applicant: SCHLUMBERGER Systèmes, 92120 Montrouge (FR)
(72) Inventor: Groeninck, Denis, c/o Schlumberger Systèmes, 92542 Montrouge Cedex (FR); Brel, Marie-Cecile, c/o Schlumberger Systèmes, 92542 Montrouge Cedex (FR)

(57) **Abstract**

A semiconductor assembly comprising a support layer, the support layer comprising a first side and a second side, the second side comprising a set of predefined areas, the set of predefined areas comprising a main predefined area, the semiconductor assembly further comprising an integrated circuit, wherein the integrated circuit is fixed onto the main predefined area.

## Description

The invention concerns, for example, hybrid cards and more generally any smart card comprising two chips into one module.

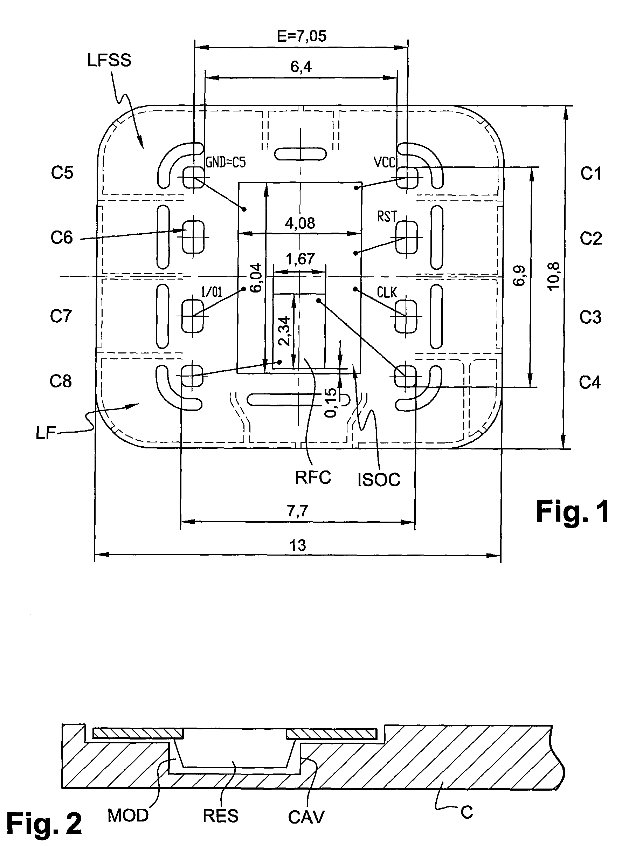

Figure 1 illustrates a method of manufacturing the module of a hybrid card. A lead-frame (LF) comprises a first side (not represented) provided with eight contact pads (not represented) and a second side (LFSS) provided with ISO 7816 connection holes C1, C2, C3, C4, C5, C6, C7 and C8. The connection holes (C1, C2, C3, C4, C5, C6, C7, C8) are mechanically and electrically connected to the contact pads.
An ISO-chip (ISOC) is placed on the second side (LFSS) of the lead-frame. An ISO chip is a chip, which is arranged to communicate with another device using an ISO protocol, for example, the ISO 7816 protocol. In the case of the ISO 7816 protocol the ISO chip is provided with at least five connection pads. In a stacking step, an RF chip provided with two connection pads, is then stacked on the ISO chip so as to form a stacked-assembly (ISOC, RFC). An RF chip is a chip, which is arranged to work with an antenna. In a connecting step, the connection pads of the ISO-chip are connected with bonding wires to the connection holes C1, C2, C3, C5 and C7 of the lead-frame (LF). In this connecting step, the connection pads of the RF chip are also connected with bonding wires to the connection holes C4 and C8 of the lead-frame (LF). Advantageously, the geometrical distribution of the connection pads of the ISO chip and of the RF chip is made so that the bonding wires of ISO chip do not cross the bonding wires of the RF chip.

As illustrated in figure 2, in a resin-depositing step, a protective resin material (RES) can be deposited on the RF chip, the ISO chip and the bonding wires so as to obtain a module (MOD). In an embedding step, the module (MOD) can be embedded in the cavity (CAV) of a card body (C) so as to obtain a hybrid card. If the height of the stacked-assembly (ISOC, RFC) is greater than the depth of the cavity (CAV), prior to the connecting step, in a thinning step, at least one of the two chips can be thinned so that the module (MOD) can be embedded in the cavity (CAV) of the card body (C) without having to modify the geometry of the cavity (CAV). The hybrid card is then inserted into, for example, a cardholder provided with an antenna or a mobile phone provided with an antenna. The RF chip of the hybrid card can thus work with the antenna of the cardholder through, in particular, the connection holes C4 and C8 and the contact pads of the lead-frame. The hybrid card can also be inserted in a mobile phone provided with an antenna. More generally the hybrid card can be inserted in any other portable device comprising an antenna, the antenna being arranged to work with the RF chip of the hybrid card.

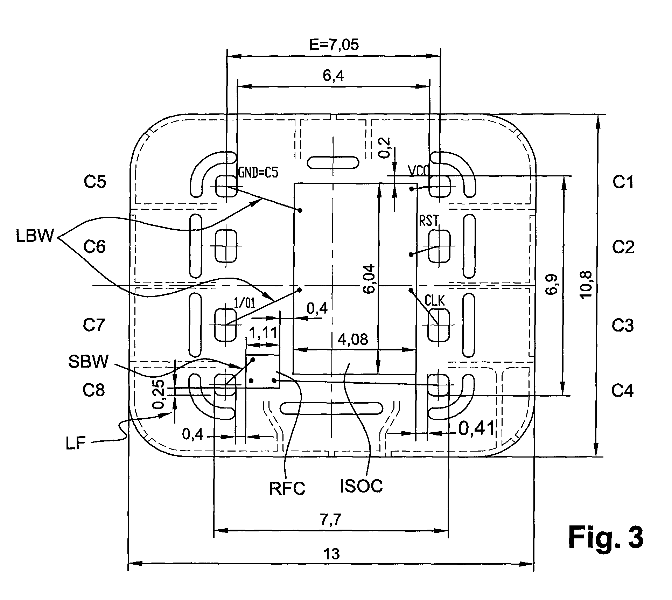

As illustrated in figure 3, the two chips may also be placed in a side-by-side configuration. In this case, the RF chip (RFC) is placed next to the ISO chip (ISOC), between, for example, a row of connection holes (C5, C6, C7, C8) and the ISO chip (ISOC). The connections pads of the ISO-chip are connected with bonding wires (LBW, SBW) to the connection holes C1, C2, C3, C5 and C7 of the lead-frame. The connection pads of the RF chip (RFC) are connected with bonding wires (LBW, SBW) to the connection holes C4 and C8 of the lead-frame (LF). The distance between the row of connection holes (C5, C6, C7, C8) and the ISO chip (ISOC) limits the width of the RF chip (RFC). In this example, the RF chip (RFC) has a length and a width of 1,1 mm. Advantageously, the ISO chip is put close to a row of connection holes (Cl, C2, C3, C4).
In this side-by-side configuration, the thinning step is not needed anymore. The manufacturing process of the hybrid card is thus easier to carry out. In addition, the risk of damaging the chip during the manufacturing process of the hybrid card is reduced thus enhancing the quality of the hybrid card. Furthermore, in a side-by-side configuration, the RF chip and the ISO chip are less close than in a stacked configuration. The risk of having some radio-frequency interferences between the RF chip and the ISO-chip is thus reduced.

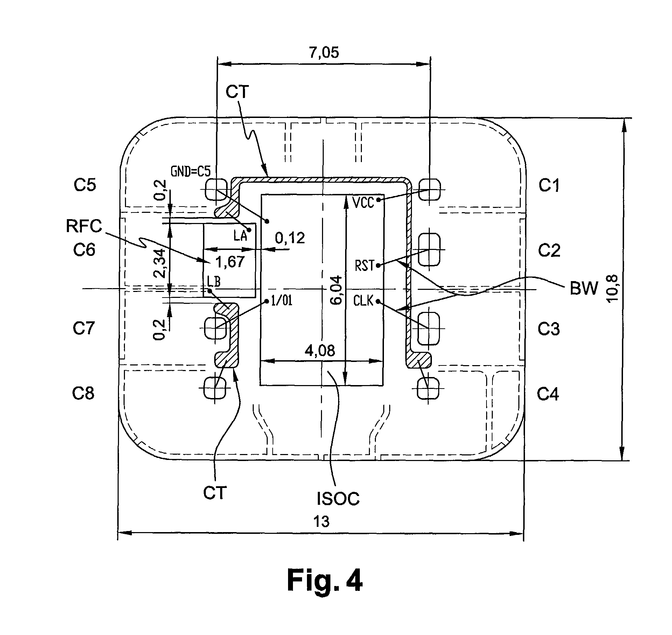

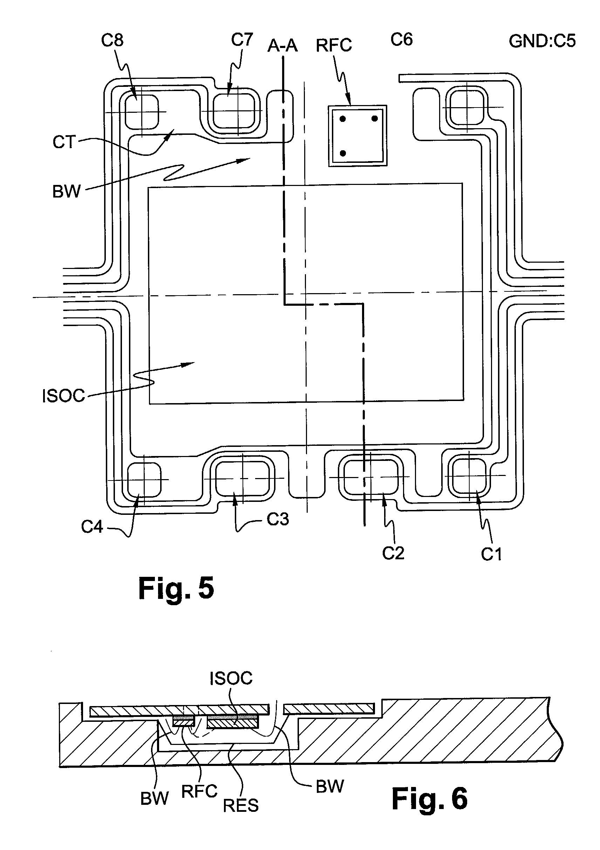

As illustrated in figures 4, 5 and 6, the RF chip (RFC) can be advantageously placed at the place of the connection hole C6. The connection hole C6 is namely generally not used in standard ISO application. In particular, this connection hole C6 can be removed. The ISO chip (ISOC) is still connected to the ISO 7816 connection holes C1, C2, C3, C5 and C7 of the module by means of bonding wires (BW). Conductive tracks (CT) are added on the second side (LFSS) of the lead-frame (LF). The connection pads of the RF chip (RFC) are connected using bonding wires (BW) to the conductive tracks (CT). The conductive tracks (CT) are connected to the connection holes C4 and C8 of the lead-frame (LF). The connection pads of RF chip (RFC) are thus connected to the connection holes C4 and C8 of the lead-frame (LF). The conductive tracks are made, for example, of copper.
By placing the RF chip (RFC) at the place of the connection hole C6, one can use a bigger RF chip than in the side-by-side configuration illustrated in figure 3. Now, as illustrated in figure 4, the RF chip can have, for example, a width of 1,67 mm and a length of 2,34mm.
Contrary to the side-by-side configuration illustrated in figure 3, the ISO chip does not need to be put close to the row of connection holes (Cl, C2, C3, C4). The length of the various bonding wires (BW) is therefore more uniform. Consequently the manufacturing process is thus easier to carry out and; in the resin-depositing step, the spreading of the protective resin material is more regular. Thus, the quality of the process is enhanced.
The RF chip is less close from the ISO chip than in the stacked configuration illustrated in figure 1. The risk of radio-frequency interferences is thus reduced. Like for the side-by-side configuration illustrated in figure 3, no thinning step is needed.

The above mentioned description describes a semiconductor assembly comprising a support layer, the support layer comprising a first side and a second side, the second side comprising a set of predefined areas, the set of predefined areas comprising a main predefined area, the semiconductor assembly further comprising an integrated circuit, wherein the integrated circuit is fixed onto the main predefined area.

In the above-mentioned description, the semiconductor assembly is, for example, a module that can be embedded in the card body of a smart card. More generally it can be any other assembly comprising a support layer and an integrated circuit. For example, the smart card can be an integrated circuit card having the geometry of an ISO bank card. But the integrated circuit card can also be a small sized card like, for example, a Subscriber Identity Module card or any other card comprising an integrated circuit.

In the above-mentioned description the support layer was a lead frame. More generally, the invention applies for all support layer comprising a set of predefined area.

In the above-mentioned description, the predefined areas correspond to the areas comprising the connection holes (C1,C2,C3,C4,C5,C6,C7,C8). The main area corresponds to the area comprising the connection hole C6. More generally, the main predefined area does not necessarily comprise a connection hole C6. Even more generally, a main predefined area is an area onto which can be fixed an integrated circuit, for example, an RF chip.

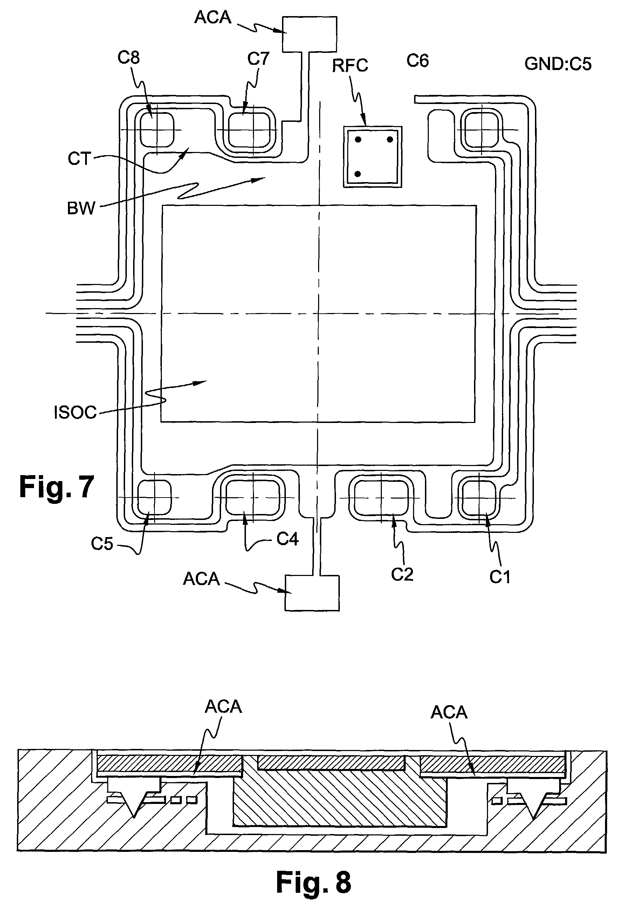

In the above-mentioned description, the integrated circuit is an RF chip. More generally, it can be any integrated circuit than can be fixed on the main predefined area. The integrated circuit can be, for example, a memory chip or a chip comprising security features against chemical, or current analysis attacks.
As illustrated in figure 7 and 8, the module (MOD) can be connected to an antenna, which is inserted on the card, by using additional conductive areas (ACA). Then the card becomes a hybrid card that can work without using a specific cardholder.
In the above-mentioned description, a wire bonding process has been used to connect a chip (RFC, ISOC) to the lead frame (LF). But any other connecting process can be used like, for example, a flip chip process.

## Claims

1. A semiconductor assembly comprising a support layer, the support layer comprising a first side and a second side, the second side comprising a set of predefined areas, the set of predefined areas comprising a main predefined area, the semiconductor assembly further comprising an integrated circuit, wherein the integrated circuit is fixed onto the main predefined area.

2. The semiconductor assembly according to claim 1, wherein the first side of the support layer comprises a set of contact pads, wherein the set of predefined area further comprises a set of auxiliary predefined areas, an auxiliary predefined area of the set of auxiliary predefined areas comprising a connection hole, the connection hole being connected to a contact pad of the set of contact pads, and wherein the integrated circuit comprises a set of connection pads, a connection pad of the set of connection pads being connected to a connection hole of an auxiliary predefined area.

3. The semiconductor assembly according to claim 2, wherein the semiconductor assembly further comprises an auxiliary integrated circuit, the auxiliary integrated circuit being fixed onto the second side of the support layer, the second integrated circuit comprising a set of auxiliary connection pads, an auxiliary connection pad of the set of auxiliary connection pads being connected to a connection hole of an auxiliary predefined area.

4. The semiconductor assembly according to claim 3 wherein the location of a predefined area on the support layer respects the ISO 7816 standard, and wherein the second integrated circuit is an ISO-chip.

5. The semiconductor assembly according to claim 2, wherein the support layer further comprises a conductive track comprising an ending, the ending being connected to a connection hole of an auxiliary predefined area.

6. The semiconductor assembly according to claim 2, wherein the integrated circuit is an RF chip.

7. An integrated circuit card comprising a card body, the card body being provided with a cavity, the cavity comprising the semiconductor assembly according to claim 1.

8. A communication device comprising an antenna, wherein the communicating device is arranged to communicate with the integrated circuit card according to claim 7.

9. The communication device according to claim 8 wherein the communication device is a cardholder.

10. The communication device according to claim 8 wherein the communication device is a mobile phone.
